(19) Europäisches Patentamt
European Patent Office
Office européen des brevets

(11) **EP 0 660 958 B1**

(12) **EUROPEAN PATENT SPECIFICATION**

(45) Date of publication and mention
of the grant of the patent:
**23.06.1999 Bulletin 1999/25**

(21) Application number: **92920842.9**

(22) Date of filing: **21.09.1992**

(51) Int Cl.⁶: **G06J 1/00**, H03H 17/02

(86) International application number:
**PCT/US92/07802**

(87) International publication number:
**WO 94/07212 (31.03.1994 Gazette 1994/08)**

(54) **SAMPLED-DATA FILTER WITH LOW DELAY**

DATENABTASTUNGSFILTER MIT NIEDRIGER VERZOEGERUNG

FILTRE DISCRET A FAIBLE TEMPORISATION

(84) Designated Contracting States:
**AT BE DE DK ES FR GB IT LU NL SE**

(43) Date of publication of application:
**05.07.1995 Bulletin 1995/27**

(73) Proprietor: **NOISE CANCELLATION
TECHNOLOGIES, INC.
Lithicum, MD 21090 (US)**

(72) Inventor: **EATWELL, Graham
Cambridge CB3 7NZ (GB)**

(74) Representative: **Read, Matthew Charles et al
Venner Shipley & Co.
20 Little Britain
London EC1A 7DH (GB)**

(56) References cited:
EP-A- 0 347 394          GB-A- 2 222 733
US-A- 4 519 084          US-A- 4 825 396
US-A- 4 872 127          US-A- 4 922 530
US-A- 5 038 269          US-A- 5 057 993

- NAECON 1990, vol. 1, May 1990 NEW YORK US, pages 64-66, KHALED JUNDI ET AL. 'Sampled Data Analog Signal Processor'
- SOUTHEASTCON '90, vol. 1, May 1990 NEW YORK US, pages 233-237, JUAN A. HENRIQUEZ ET AL. 'Sample Rate Conversion for Digital Audio Processing'

# EP 0 660 958 B1

## Description

The present invention relates to an adaptive filter with low throughput delay comprising: input means for receiving an input signal; output means for outputting a filtered signal; a first filter path between the input means and the output means, the first filter path including sampling means for providing a first signal at a first sampling rate, first sampled-data filter means for filtering said first signal to produce a second signal, and anti-imaging filter means for filtering the second signal to produce a first output signal; a second filter path between the input means and the output means, the second filter path including an additional filter means, having a low throughput delay compared to the first sampled data filter means, for filtering input signals from the input means to produce a second output signal; and combining means for combining said first output signal and said second output signal to produce a combined output signal.

There are many applications where filtering is required with a minimum of delay through the filter. One such application is in real-time control systems used for active noise cancellation.

Modern control systems often use sampled-data filters which may be analog devices such as charge coupled devices but are more often digital filters. There are inherent delays associated with a sampled-data filter. For example, in a digital filter these are due to the anti-aliasing filters (which may be digital or analog), the anti-imaging filters (which may be digital or analog), the sample and hold of the Digital to Analog Converter (DAC) and the computation time of the digital processor.

The first three of these are related to the sampling period of the digital filter. They can be reduced by increasing the sampling rate of the digital filter. However, this requires an increase in the computational power of the processor and results in increased cost and electrical power consumption.

For some applications a fixed filter is sufficient, and there have been attempts in the past to modify digital filters by combining them with analog components.

It is known that the delay associated with the filter can be avoided if the digital filter is combined with an analog circuit in such a way that there are a least two paths through the filter, one of which avoids the digital filter.

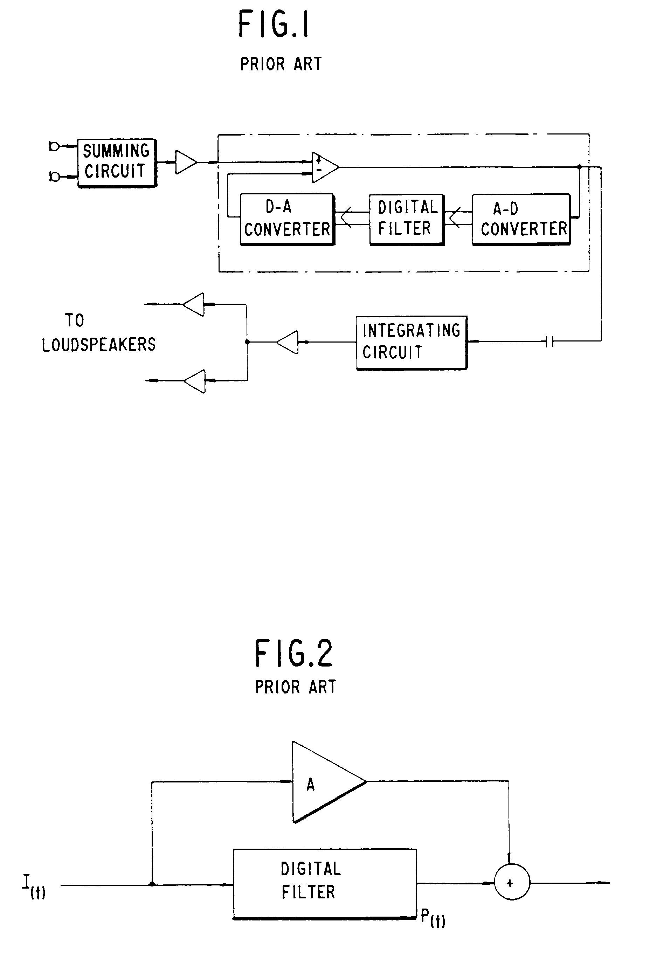

For example, in GB-A-2142091, "Attenuation of sound waves", Swinbanks describes a filter, shown in Figure 1, which comprises a fixed analog gain with digital FIR filter in the feedback path and in GB-B-2222733, "Improved digital filter with an analog path", Harper and Ross describe a fixed analog filter with a digital FIR filter in a parallel path. This is shown in Figure 2.

For most practical applications however, it is necessary to adjust the overall response of the filter in order to maintain the best control performance in a changing environment. There are no previously known methods for adapting combined filters of the type described by Swinbanks or by Harper and Ross.

There is some discussion by Swinbanks of how to determine the digital filter coefficients when a fixed-gain analog amplifier is used, but this is only possible if the characteristics of the system to be controlled are fixed and can be determined in advance. There is no discussion of how to choose the gain of the analog amplifier.

While there is some discussion by Harper and Ross of how to determine the desired characteristic of the analog filter when the digital filter is fixed, there is no discussion of how to determine the characteristics jointly.

The desired response can be more closely matched by designing the two filters together. Additionally, it is often desirable to use a fully adaptive control system for practical control applications. This avoids the need to redesign the system for each new application and allows the control system to be used when the system to be controlled varies with time.

The digital filters described by Swinbanks and by Harper et al. are for use with feedforward active control systems. For this type of control system an "upstream" sensor is used to obtain an advance measurement of the noise to be canceled. In this application, the characteristic of the digital filter depends upon the acoustic response of the physical system and on the characteristics of the actuator. These may be slowly varying over time. However, feedback control systems do not use an "upstream" sensor, instead they only use sensors in the region where noise control is required. In this case the information received from the sensor is generally too late, and the control system must be able to predict the noise. Any delay through the filter will make this prediction more difficult. The prediction is strongly dependent upon the characteristics of the noise, and so the filter characteristics must be varied as the noise varies. Hence, active feedback control requires a fully adaptive control system with a low throughput delay.

Accordingly, it is an object of this invention to provide a filter with a low throughput delay without using a processor.

Another object of this invention is to provide a filter means having multiple paths therethrough, one of them being a higher speed path than at least one of the others.

A further object of this invention is to provide a parallel path filtering means wherein the characteristics of the filters are selected to minimize the difference between overall filter response and the desired response.

A filter according to the present invention, is characterised by anti-aliasing filter means in the first filter path between the input means and the sampling means, and adaption means responsive to an error signal sampled at said

2

first sampling rate and configured to adjust the characteristics of said first sampled-data filter means and said additional filter means, said error signal being representative of the difference between the overall filter response and a desired filter response.

Preferably, the adaption means is also responsive to said first signal.

Preferably, the error signal is filtered through models of said anti-aliasing filter means and said anti-imaging filter means before being used to adjust the characteristics of said additional filters.

Preferably, the additional filter means comprises one or more second sampled-data filters with a second sampling rate and one or more coefficients, said second sampling rate being higher than said first sampling rate and the number of coefficients in said second sampled-data filter being less than the number of coefficients in said first sampled-data filter. More preferably, the first sampled-data filter means and said second sampled-data filters are digital filters. Still more preferably, the input signal is obtained from a single analog to digital converter which may be a one-bit (sigma delta) converter.

Preferably, the first and second output signals are digital signals which are combined and passed to a single digital to analog converter. More preferably, the single digital to analog converter is a one-bit (sigma delta) converter.

The additional filter means may comprise an analog filter or gain rather than a digital sampled-data filter. In this case, the analog filter or gain is preferably digitally controlled.

Preferably, the adaption means operates to minimize the mean square value of said error signal.

Preferably, the input means, the output means, the additional filter means and the combining means are implemented on a single integrated circuit chip.

Preferably, the first sampled-data filter means is a digital filter, and the first sampled-data filter means and the adaption means are implemented on a single integrated circuit chip.

A multichannel adaptive filter may be constructed with a plurality of single-channel filters, each single-channel filter being in accordance with the present invention.

A still further object of this invention is to provide a method of avoiding filter delays in an active noise cancellation circuit.

According to the present invention, there is provided a control system for reducing or modifying an original disturbance, the system comprising: an input sensor providing an input signal related at least in part to an original disturbance; an adaptive filter according to the present invention for filtering said input signal to produce a drive signal; an actuator responsive to said drive signals to produce a control disturbance; and a residual sensor responsive to the combination of an original disturbance and said control disturbance and producing at least one residual signal, wherein the adaptive filter is adapted in dependence on said residual signal. Such a control system may include additional filter means to compensate for any feedback between the actuator and the input sensor. The control system may be a multi-input/multi-output control system.

According to the present invention, there is provided a method of configuring a filter according to the present invention, the method comprising:

forming a matrix $U$, of filtered input signals,
calculating a vector, $\underline{C}$, of filter coefficients according to

$$\underline{C} = - <U^T U>^{-1} <U^T \underline{y}>$$

where $\underline{y}$ is a vector of desired signals and the angled brackets denote an expected value, and
applying $\underline{C}$ to a filter according to the present invention.

According to the present invention, there is also provided a method of configuring a filter according to the present invention, the method comprising:

forming a matrix, $U_s$, of filtered input signals,
calculating a vector, $\underline{C}$, of filter coefficients according to

$$\underline{C} = - <U_s^T U_s>^{-1} < U_s^T H\underline{y}>$$

where $-\underline{y}$ is a vector of desired signals and $H$ is a matrix corresponding to the response of said anti-aliasing and said anti-imaging filters and the angled brackets denote an expected value, and
applying $\underline{C}$ to a filter according to the present invention.

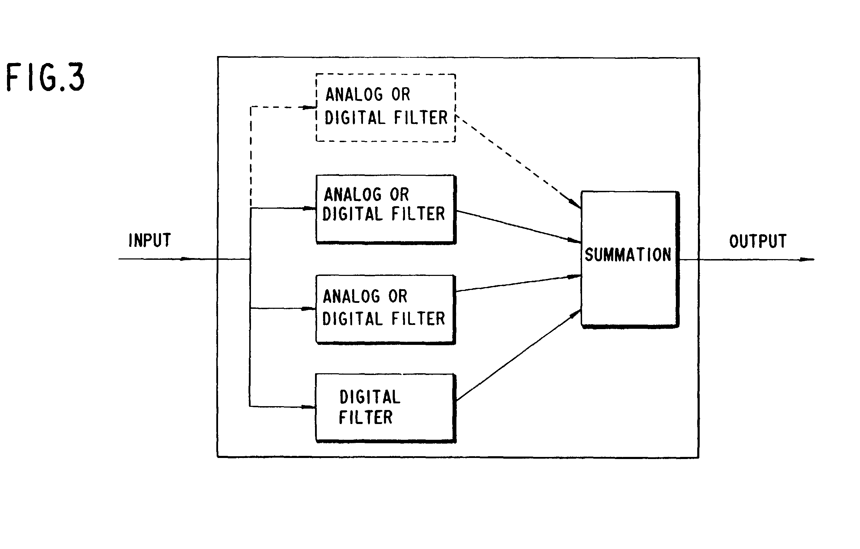

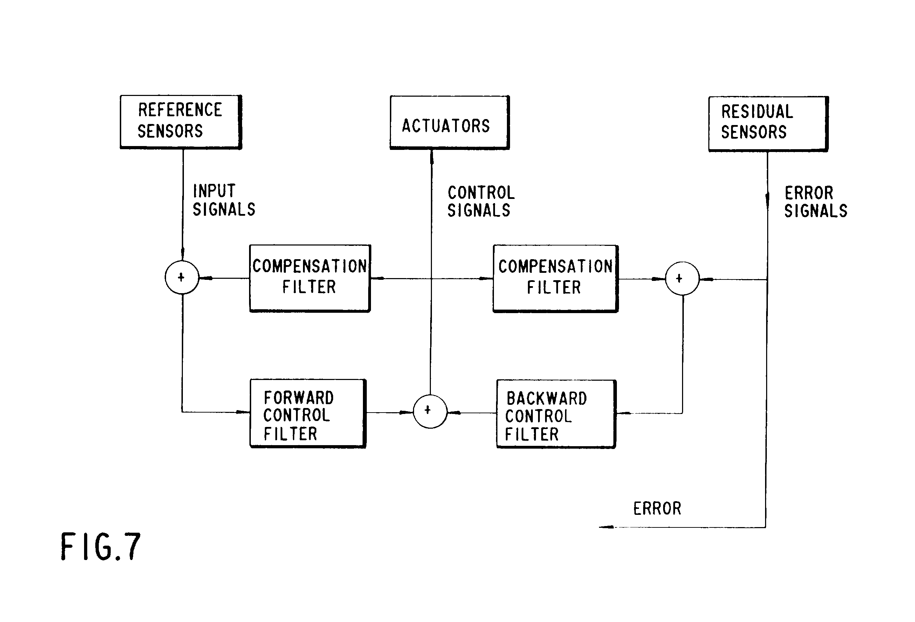

Embodiments of the present invention will now be described, by way of example, with reference to Figures 3 to 12 of the accompanying drawings, in which:

Figure 1 shows a circuit from background art;
Figure 2 is a diagrammatic view of a background art circuit;
Figure 3 is a diagrammatic view of a low delay filter;
Figure 4 is a diagrammatic view of a recursive filter;
Figure 5 is a diagrammatic view of another type of recursive filter;
Figure 6 is a diagrammatic view of an adaptive filter;
Figure 7 is a diagrammatic view of an active control system;
Figure 8 is a diagrammatic view of a control system with a two-path filter;
Figure 9 is a diagrammatic view of a multi-channel control system;
Figure 10 is a diagrammatic view of an adaptive feedforward control system;
Figure 11 is a diagrammatic view of an adaptive feedback control system; and
Figure 12 is a diagrammatic view of a general purpose sigma delta chip.

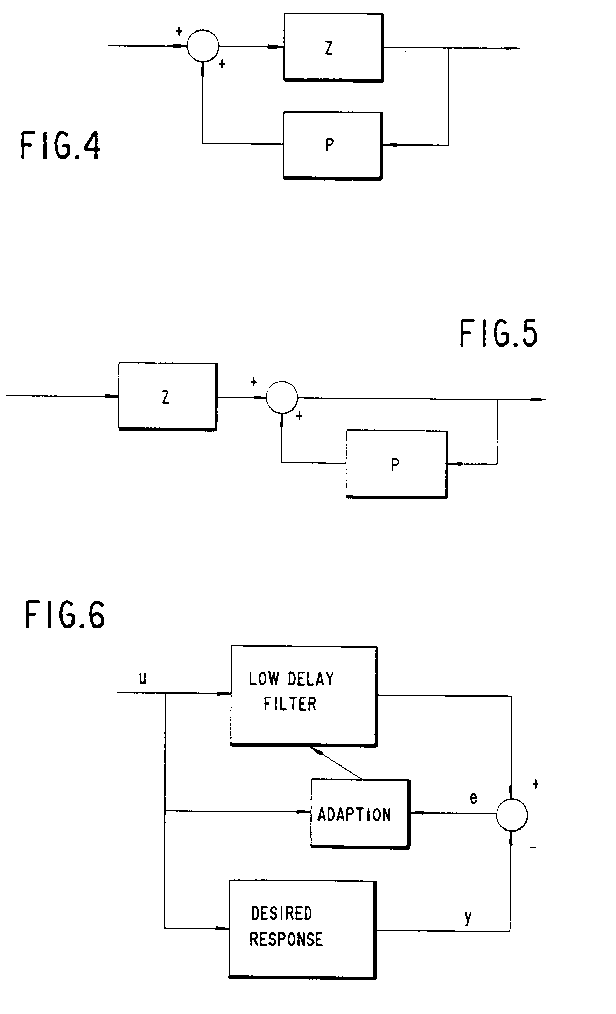

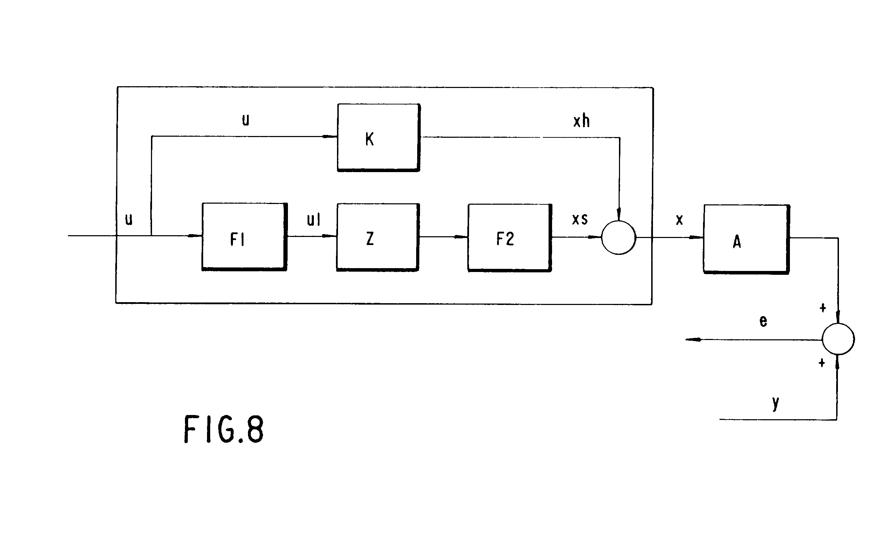

By way of explanation we shall describe a filter comprising a slow speed Finite Impulse Response (FIR) sampled-data filter in parallel with a high speed sampled-data filter with sampling period $T$. This filter is shown in Figure 8. Also included in Figure 8 is physical system labeled A. For some adaptive filters this may have a unity response. The desired signal, $-y$, may be the signal due to an unwanted disturbance or may be generated from the filter input as in Figure 6.

In Figure 8, $K$ is the gain of the high speed filter (sampled-data or continuous), $F_l$ is the anti-aliasing filter, $F_2$ is the anti-imaging filter and $Z$ is the slower speed sampled-data filter.

At time $kT$, the output from the anti-aliasing filter, sampled at the higher sampling rate, is

$$u_1(kT) = \sum_l F_1(lT).u(kT - lT)$$

where $F_l(t)$ is the impulse response of the anti-aliasing filter and u(t) is the common high speed input signal.

The sampling period of the slow speed filter is $NT$, which means that the filter uses only every $N$-th value of the high speed input.

We define the operator $|.|$ by

$$|k| = N.(k \text{ div } N)$$

The output from the anti-imaging filter at time $t$ during the $k$-th sampling period is $x_s(t)$, given by

$$x_s(kT) = \sum_n z_n.u_{12}\left(|k - Nn|\right)$$

where

$$u_{12}\left(|k - Nn|\right) = \sum_m F_2(mT).u_1\left(|k - m - Nn|T\right)$$

and where $z_n$ is the n-th filter coefficient and $F_2(t)$ is the impulse response of the anti-imaging filter. The $n$-summation is over all filter coefficients.

In one embodiment of the invention the high speed path is placed in parallel with FIR filter as shown in Figure 8.

If the high speed path is an analog amplifier the output is

$$x_h(t) = K.u(t),$$

where $K$ is the amplifier gain.

Alternatively, the high speed path can be a sampled-data filter with a single coefficient running $N$ times faster than the slow speed filter. The output from this filter is

$$x_h(kT) = K.u(kT),$$

where $K$ is the coefficient value. A sampled-data filter with more coefficients could be used.

The high and slow speed outputs are summed to give the controller output signal, $x(t)$. If the high speed filter is a sampled-data filter the outputs can be combined as sampled-data signals or as analog signals. Also if the high speed filter is a sampled-data filter its output must usually be passed through an anti-imaging filter.

In a control system the output signal is used to drive an actuator which produces a controlling disturbance.

In an adaptive control system, a residual sensor is often used to measure the combination of the original disturbance and the controlling disturbance. This signal is then used to adjust or adapt the coefficients of the filters in order to obtain some desired effect (usually a reduction in the level of the disturbance).

The sampled response at a residual sensor at time $rT$ is

$$e(rT) = y(rT) + \sum_m A(rT - mT).(x_s + x_h)(mT),$$

where $y$ is the part of the response not due to the controller, and $A(t)$ is the response corresponding to a unit impulse at the controller output. If a sampled-data high speed path is used then $A(t)$ includes the anti-imaging filter for the high speed filter and the anti-imaging filter on the residual sensor.

This residual signal can be written in terms of the filter coefficients and the input signals

$$e(rT) = y(rT) + v(rT)K + \sum_n w(r,n).z_n,$$

where

$$v(rT) = \sum_l A(rT - lT).u(lT)$$

and

$$w(r,n) = \sum_l A(rT - lT).u_{12}(|l - Nn|T).$$

We can express the vector of successive samples in matrix notation as

$$\underline{e} = \underline{y} + \underline{v}K + W\underline{Z},$$

where

$$\underline{e} = \{e_n, e_{n-1}, e_{n-2}, \ldots, e_{n-m}\}^T,$$
$$\underline{y} = \{y_n, y_{n-1}, y_{n-2}, \ldots, y_{n-m}\}^T,$$
$$\underline{v} = \{v_n, v_{n-1}, v_{n-2}, \ldots, v_{n-m}\}^T,$$
$$\underline{Z} = \{z_0, z_1, z_2, \ldots, z_{m-1}\}^T,$$

and *W* is the circular matrix

$$W = \begin{bmatrix} w'_n & w'_{n-1} & w'_{n-2} & \cdot & \cdot & w'_{n-m} \\ w'_{n-1} & \cdot & & \cdot & \cdot & \cdot \\ w'_{n-2} & \cdot & \cdot & & \cdot & \cdot \\ \cdot & \cdot & \cdot & & \cdot & \cdot \\ w'_{n-m} & \cdot & \cdot & & \cdot & w'_{n-2m} \end{bmatrix}$$

This can be written more compactly as

$$\underline{e} = \underline{y} + U\underline{C},$$

where *U* is the matrix *W* augmented with the vector $\underline{v}$, and $\underline{C}$ is the vector of coefficients, $\underline{Z}$, augmented with the amplifier gain *K*. That is

$$U = [\underline{v} : W],$$

and

$$\underline{C} = \{K, z_0, z_1, \ldots, z_m\}^T$$

The equation for e is in a standard form for sampled-data filters, and a variety of methods may be used to determine the vector of filter/coefficients, $\underline{C}$.
For example, for stationary signals, y, the optimal vector of coefficients can be defined to be that which minimizes the variance (mean square) of the signal at the sensor, i.e. that which minimizes

$$J = < \underline{e}^T \underline{e}>.$$

The optimal vector of coefficients is

$$\underline{C} = - <U^T U>^{-1} <U^T \underline{y}>.$$

Other optimal vectors can be found which minimize *J,* or other cost functions, subject to various constraints.
We therefore have a means for determining the coefficients of a filter with low throughput delay.
For non-stationary signals, that is those whose statistics vary with time, or for time-varying systems, various adaptive algorithms can be used. One example is to use an adaptive update. At the *k-th* update step this takes the form,

$$\underline{C}^{k+1} = (1 - \mu L)\underline{C}^k - \mu B\underline{e}^k,$$

where $\mu$ is the convergence step-size, *B* is a matrix which is dependent on the controller input signal and the system response *(A)*, and *L* is a matrix (often a diagonal matrix) which can depend upon both the system response and the controller output signal.
Examples are,

$$B = U^T,$$

$$L = \lambda I,$$

which gives an LMS or gradient type algorithm, and

$$B = <U^T U + \lambda\ I>^{-1}\ U^T,$$

$$L = I - BU.$$

which gives Newton or steepest descent type algorithm. In the above $\lambda$ is a non-negative number and $I$ is the identity matrix. Many variations are possible.

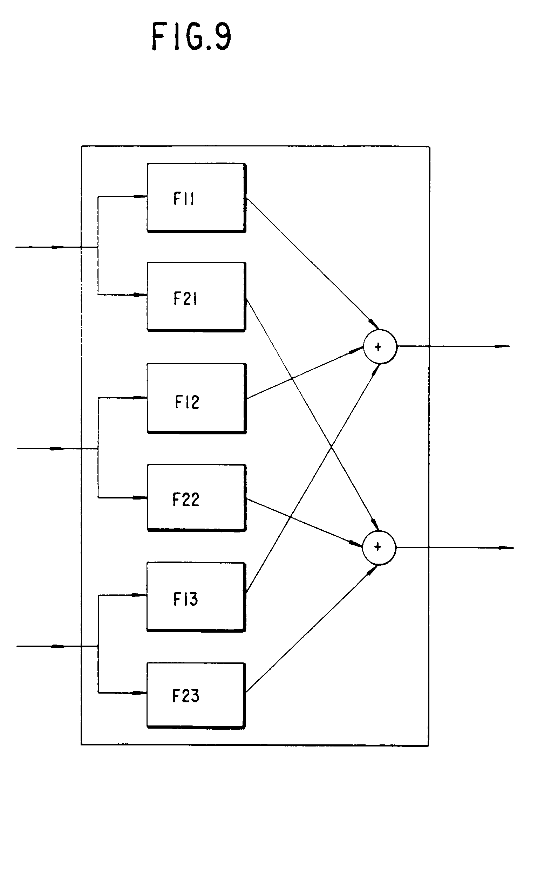

The same approach can be used for multi-channel systems, even when there is significant interaction between the channels. An example of a multi-channel filter with 3 inputs and 2 outputs is shown in Figure 9. It utilizes 6 single channel filters, whose outputs are combined as shown in the figure.

Note however, that in the above derivation the error signal and the filtered input signal were sampled at the sampling rate of the high rate sampled-data filter This means that the information for the adaptive update must be collected at this rate. Furthermore, the impulse response, $A(t)$, does not include the anti-imaging filter for the slow sampled-data filter, so it is not easy to measure, and the filtered input signal, $v(t)$, is difficult to calculate since it involves a convolution with high sampling rate data. For applications where the filter characteristic can be determined off-line this may not be a problem, but one of the purposes of the current invention is to minimize the computational requirements. This is achieved by using a design or adaption approach which only uses the data sampled at the slower sampling rate.

One way of modifying the above approach, which constitutes one aspect of this invention, will now be described. This approach seeks to use only slow-rate data to adjust the filter coefficients. This further reduces the computational requirements for the signal processor.

Rather than use the cost function $J$ described above, a different cost function is used. This cost function corresponds to minimizing the filtered error signal

$$(F_1 * F_2 * e)(rT) = (F_1 * F_2 * y)(rT) + v_s(rT)K + \sum_n w_s(rT,n).z_n$$

where

$$v_s(rT) = \sum_l A_s(rT - lT).u_1(lT),$$

$$w_s(rT,n) = \sum_l (F_1 * A_s)(rT - lT).u_{12}(|l - Nn|T)$$

$$= \sum_l (F_1 * F_2 * A_s)(rT - lT)u_1(|l - Nn|T)$$

and $A_s = F_2 * A$. The star denotes the convolution operator.

This error can sub-sampled at the slower sampling rate, without introducing aliasing, to give

$$(F_1 * F_2 * e)(rNT) = (F_1 * F_2 * y)(rNT) + v_s(rNT)K + \sum_n w_s((r - 1)NT).z_n$$

where

7

$$w'_s(rNT) = \sum_l (F_1 * F_2 * A_s)((r-l)NT).u_1(lNT)$$

This form of the equation is preferred since the impulse response $A_S$ can be measured directly at the slow sampling rate, and the signal $u_1 = F_1 * u$ is available at the slow sampling rate as the input to the slow sampled-data filter.

The new cost function is given by

$$J = <\underline{e}^T H^T H \underline{e}>,$$

where $H$ is the circular matrix corresponding to a filter with response $F_1 * F_2$.

In matrix notation

$$H\underline{e} = H\underline{y} + U_s\underline{C},$$

where the matrix of signals $U_S$ is defined analogously to $U$, except that instead of $v(t)$ and $w(t)$ it uses the filtered signals $v_S(t)$ and $w_S(t)$.

The update equations are defined analogously to those using the higher sampling rate data (with $U$ replaced by $U_S$).

The process of minimizing the filtered error signal rather than the error signal itself allows the filter coefficients to be updated using only data sampled at the slow rate. This results in a significant reduction in the amount of computation required.

One of the requirements of the filter described above is for data at two different sampling rates. This can achieved by using separate analog-to-digital converters for each sampling rate, each preceded by the appropriate analog anti-aliasing filter. Similarly, separate digital-to-analog converters can be used for each filter output. The analog outputs would each pass through the appropriate anti-imaging filter before being summed to produced the combined output.

An alternative approach is to use a single high rate analog-to-digital converter preceded by the appropriate analog anti-aliasing filter. The slower rate data can then be obtained by digital filtering and decimation (sub-sampling). Similarly, the low rate digital output can be interpolated and filtered to produce a digital signal at the higher rate. This signal can then be digitally combined with the high rate output signal before being passing to a common digital-to-analog converter and anti-aliasing filter.

This type of decimation, interpolation and filtering is currently found in one-bit converters (often known as sigma-delta converters or codecs). Many efficient techniques have been developed. One of the advantages of these conveners is that the filtering and conversion for several inputs and outputs can easily be achieved by a single integrated circuit chip. This results in a low-cost device. The initial sampling rates can be very high (often above 1 megaHertz) and the data is then decimated in several stages before the final digital output is obtained. These devices can easily be modified to provide several outputs at different rates and so they are ideally suited for use with the filters of this invention.

The adaption process requires knowledge of the system response $A_S$. Since this is only required at the slow sampling rate it can be measured by usual techniques such as an initial calibration (using a test signal) and/or using on-line system identification (as described, for example, by Eriksson, US patent 4,667,676.

For some control applications the input (reference) signal is not isolated from the actuator. This is always the case for feedback control since the reference signal and the error signal are obtained from the same sensor. This situation results in a feedback loop from the controller output to its input which complicates the adaption process. However, there are well known techniques for dealing with this (see Eriksson, US patent 4,667,676 for example). One approach is to compensate for the feedback by modeling the feedback path with an additional fixed or adaptive filter and subtracting an estimate of the feedback component from the input signal (see Chaplin, US Patent No. 4122303). It may be necessary to use an additional low delay filter to model this feedback accurately. This filter can be adapted in the same way as the control filter by considering the error between the actual response to a test signal and the predicted response (as in Figure 6). Similarly, a filtered version of this error signal can be used to reduce the amount of processing required.

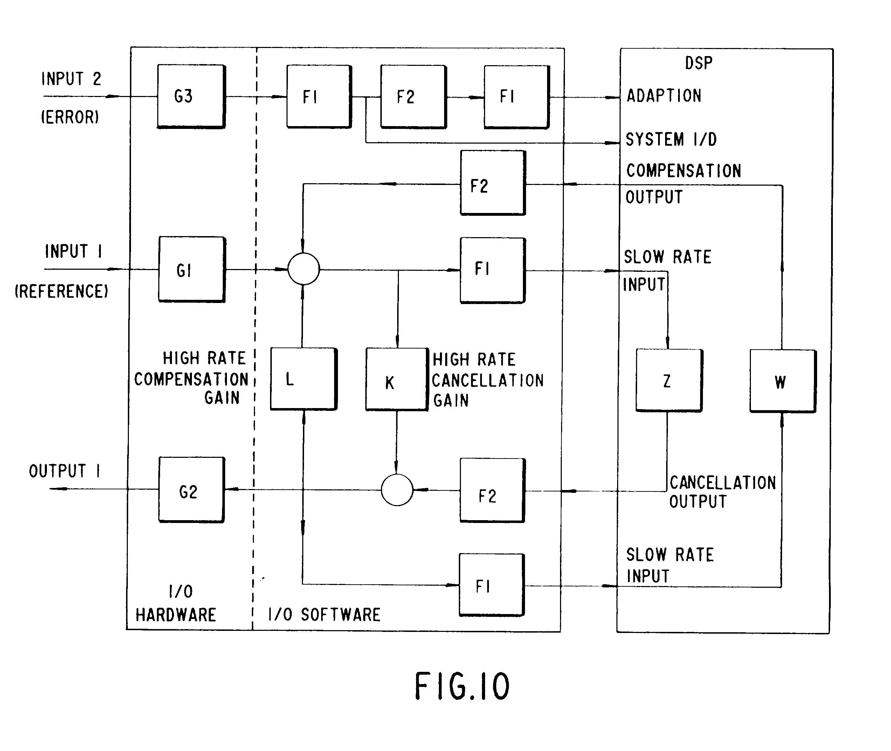

An example of a single channel adaptive feedforward (AFF) controller is shown in Figure 10. This utilizes a sigma delta converter chip with two inputs and one output, and a general purpose Digital Signal Processing chip (DSP). In another embodiment the DSP is replaced by custom signal processing hardware such as an adaptive filter chip. In Figure 10 $F1$ denotes a digital low pass filter and decimator (sub-sampler) and $F2$ denotes a digital interpolator. $G1$

denotes the analog anti-aliasing filter, 1-bit analog to digital converter and first stage decimator and G2 denotes the 1-bit digital to analog converter and analog anti-imaging filter. The controller includes compensation for the actuator feedback to the reference sensors (using both a high rate gain, *L*, and a slower rate digital filter, *W*). In this embodiment the anti-aliasing and interpolation filtering is all done on the Sigma-Delta chip, as is the filtering of the error signal. This means that the DSP is only, using the slow speed digital data.

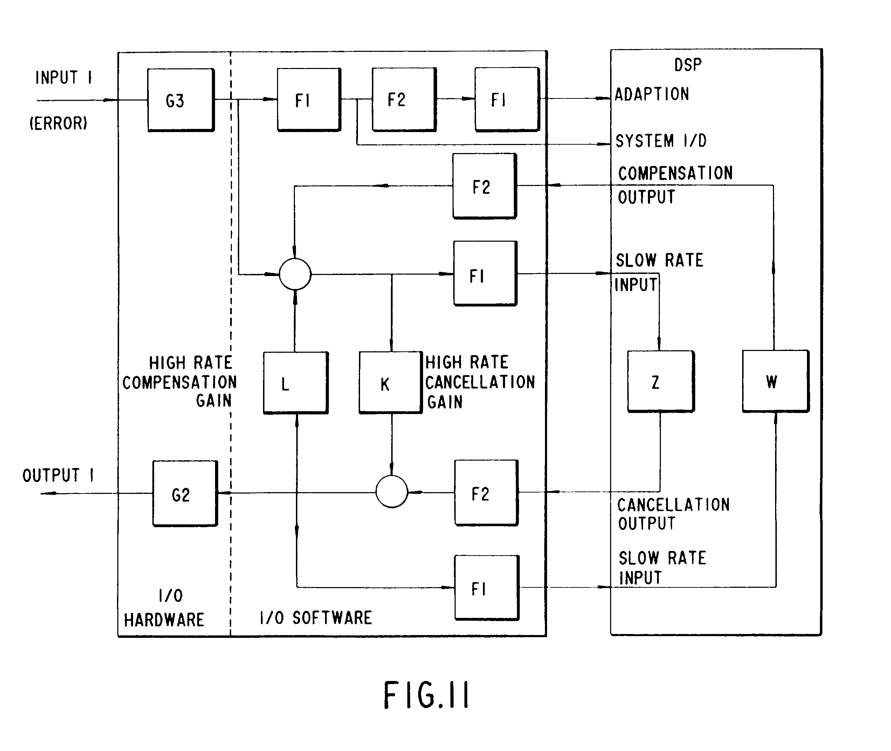

An example of a single channel adaptive feedback (AFB) controller is shown in Figure 11. This is very similar to the AFF controller but utilizes a sigma delta converter chip with a single input and one output.

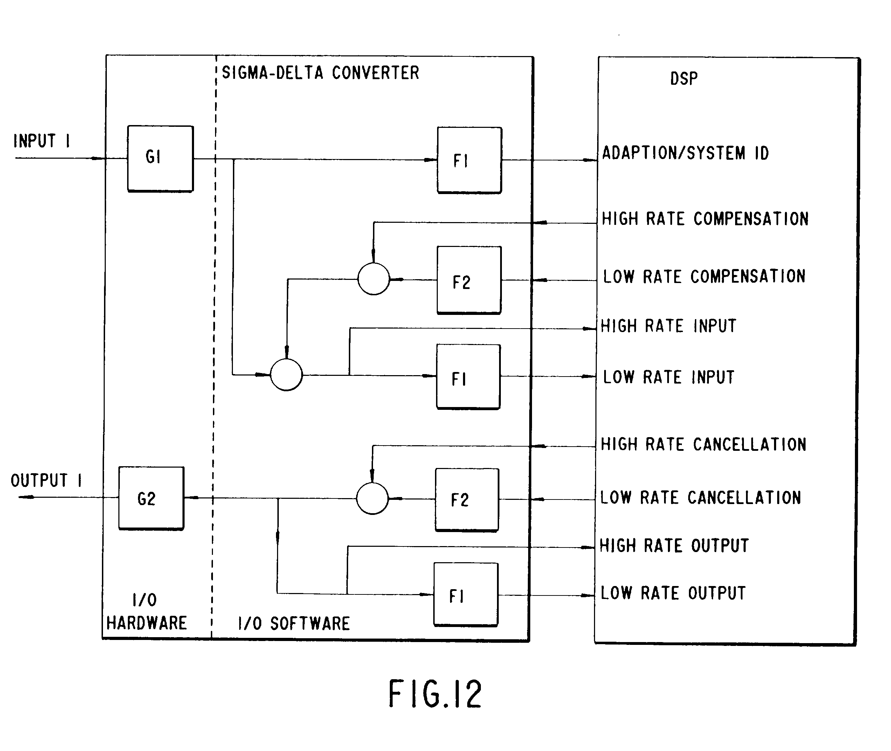

For multi-channel applications it is sometimes necessary to compensate for the feedback between each actuator and sensor. In this case, coupling pairs of inputs and outputs as in Figure 10 is not sufficient. In this case it may be necessary to do the high rate filtering on the DSP chip. An example of an input/output chip for this application is shown in Figure 12. Only one input and output are shown, but the structure is just repeated for additional channels.

The input/output hardware and the signal processing hardware and the associated electronics can be combined on a single integrated circuit chip as shown in Figure 13 for example. This results in a high performance, low cost control system which can be applied to many noise and vibration control problems.

Examples of applications where low cost controllers are required include noise canceling headsets, noise and vibration control for home appliances such as vacuum cleaners and range hoods, electronic mufflers for automobiles, noise filters for communication signals and vibration controllers for active panels and enclosures.

## Claims

1. An adaptive filter with low throughput delay comprising:-

   input means for receiving an input signal (u);
   output means for outputting a filtered signal (x);
   a first filter path between the input means and the output means, the first filter path including sampling means for providing a first signal at a first sampling rate, first sampled-data filter means (Z) for filtering said first signal to produce a second signal, and anti-imaging filter means (F2) for filtering the second signal to produce a first output signal (xs);
   a second filter path between the input means and the output means, the second filter path including an additional filter means (K), having a low throughput delay compared to the first sampled data filter means, for filtering input signals (u) from the input means to produce a second output signal (xh); and
   combining means for combining said first output signal (xs) and said second output signal (xh) to produce a combined output signal (x);

   **characterised by**

   anti-aliasing filter means (F1) in the first filter path between the input means and the sampling means, and adaption means responsive to an error signal (e) sampled at said first sampling rate and configured to adjust the characteristics of said first sampled-data filter means and said additional filter means, said error signal (e) being representative of the difference between the overall filter response and a desired filter response (*y*).

2. An adaptive filter according to claim 1, wherein said adaption means is also responsive to said first signal.

3. An adaptive filter according to claim 1, wherein said error signal (e) is filtered through models of said anti-aliasing filter means (F1) and said anti-imaging filter means (F2) before being used to adjust the characteristics of said additional filter means (K).

4. An adaptive filter according to claim 1, wherein the additional filter means (K) comprises one or more second sampled-data filters with a second sampling rate and one or more coefficients, said second sampling rate being higher than said first sampling rate and the number of coefficients in said second sampled-data filter being less than the number of coefficients in said first sampled-data filter.

5. An adaptive filter means according to claim 4, wherein said first sampled-data filter means (Z) and said second sampled-data filters are digital filters.

6. An adaptive filter means according to claim 5, in which said input signal (u) is obtained from a single analog to digital converter.

7. A filter means according to claim 6, wherein said single analog to digital converter is a one-bit (sigma delta) converter.

8. A filter means according to claim 5, wherein said first and second output signals (xh, xs) are digital signals which are combined and passed to a single digital to analog converter.

9. A filter means according to claim 8, wherein the single digital to analog converter is a one-bit (sigma delta) converter.

10. An adaptive filter according to claim 1, wherein the additional filter means (K) is an analog filter or gain.

11. An adaptive filter according to claim 10, wherein the analog filter or gain is digitally controlled.

12. An adaptive filter according to claim 1, wherein said adaption means operates to minimize the mean square value of said error signal (e).

13. An adaptive filter according to claim 1, wherein said input means, said output means, said additional filter means (K) and said combining means are implemented on a single integrated circuit chip.

14. An adaptive filter according to claim 1, wherein said first sampled-data filter means (Z) is a digital filter and said first sampled-data filter means (Z) and said adaption means are implemented on a single integrated circuit chip.

15. A multichannel adaptive filter comprising a plurality of single-channel filters (F11, F21, F12, F22, F13, F23) each single-channel filter being in accordance with a preceding claim.

16. A control system for reducing or modifying an original disturbance, the system comprising:

an input sensor providing an input signal (INPUT 1) related at least in part to an original disturbance;
an adaptive filter according to any one of claims 1 to 14 for filtering said input signal (INPUT 1) to produce a drive signal (OUTPUT 1);
an actuator responsive to said drive signals to produce a control disturbance; and
a residual sensor responsive to the combination of an original disturbance and said control disturbance and producing a residual signal (INPUT 2),
wherein the adaptive filter is adapted in dependence on said residual signal (INPUT 2).

17. A control system according to claim 16, including additional filter means (L, W) to compensate for any feedback between the actuator and the input sensor.

18. A method of configuring a filter according to any one of claims 1 to 14, the method comprising:

forming a matrix $U$, of filtered input signals,
calculating a vector, $\underline{C}$, of filter coefficients according to

$$\underline{C} = - <U^T U>^{-1} <U^T \underline{y}>$$

where $\underline{y}$ is a vector of desired signals and the angled brackets denote an expected value, and
applying $\boldsymbol{C}$ to a filter according to any of claims 1 to 14.

19. A method of configuring a filter according to any one of claims 1 to 14, the method comprising:

forming a matrix, $U_s$, of filtered input signals,
calculating a vector, $\underline{C}$, of filter coefficients according to

$$\underline{C} = - <U_s^T U_s>^{-1} <U_s^T H \underline{y}>$$

where $-\underline{y}$ is a vector of desired signals and $H$ is a matrix corresponding to the response of said anti-aliasing and said anti-imaging filters and the angled brackets denote an expected value, and

applying <u>C</u> to a filter according to any one of claims 1 to 14.

**Patentansprüche**

1. Adaptives Filter mit niedriger Durchsatzverzögerung, das folgendes aufweist:

   eine Eingabeeinrichtung zum Empfangen eines Eingangssignals (u);
   eine Ausgabeeinrichtung zum Ausgeben eines gefilterten Signals (x);
   einen ersten Filterweg zwischen der Eingabeeinrichtung und der Ausgabeeinrichtung, wobei der erste Filterweg aufweist: eine Abtasteinrichtung zum Bereitstellen eines ersten Signals mit einer ersten Abtastrate, eine erste Abtastdaten-Filtereinrichtung (Z) zum Filtern des ersten Signals, um ein zweites Signal zu erzeugen, und eine Anti-Abbildungs(Anti-Imaging)-Filtereinrichtung (F2) zum Filtern des zweiten Signals, um ein erstes Ausgangssignal (xs) zu erzeugen;
   einen zweiten Filterweg zwischen der Eingabeeinrichtung und der Ausgabeeinrichtung, wobei der zweite Filterweg eine zusätzliche Filtereinrichtung (K), die im Vergleich zur ersten Abtastdaten-Filtereinrichtung eine niedrige Durchsatzverzögerung aufweist, zum Filtern von Eingangssignalen (u) von der Eingabeeinrichtung aufweist, um ein zweites Ausgangssignal (xh) zu erzeugen; und
   eine Kombiniereinrichtung zum Kombinieren des ersten Ausgangssignals (xs) und des zweiten Ausgangssignals (xh), um ein kombiniertes Ausgangssignal (x) zu erzeugen;

   **gekennzeichnet durch**

   eine Antialiasing-Filtereinrichtung (F1) auf dem ersten Filterweg zwischen der Eingabeeinrichtung und der Abtasteinrichtung; und
   eine Adaptionseinrichtung, die auf ein mit der ersten Abtastrate abgetastetes Fehlersignal (e) anspricht und konfiguriert ist, die Eigenschaften der ersten Abtastdaten-Filtereinrichtung und der zusätzlichen Filtereinrichtung einzustellen, wobei das Fehlersignal (e) den Unterschied zwischen der Gesamtfilterantwort und einer erwünschten Filterantwort (y) repräsentiert.

2. Adaptives Filter nach Anspruch 1, bei dem die Adaptionseinrichtung auch auf das erste Signal anspricht.

3. Adaptives Filter nach Anspruch 1, bei dem das Fehlersignal (e) durch Modelle der Antialiasing-Filtereinrichtung (F1) und der Anti-Abbildungs-Filtereinrichtung (F2) gefiltert wird, bevor es verwendet wird, um die Eigenschaften der zusätzlichen Filtereinrichtung (K) einzustellen.

4. Adaptives Filter nach Anspruch 1, bei dem die zusätzliche Filtereinrichtung (K) eines oder mehrere zweite Abtastdaten-Filter mit einer zweiten Abtastrate sowie einen oder mehrere Koeffizienten umfaßt, wobei die zweite Abtastrate größer ist als die erste Abtastrate, und wobei die Anzahl der Koeffizienten im zweiten Abtastdaten-Filter kleiner ist als die Anzahl der Koeffizienten im ersten Abtastdaten-Filter.

5. Adaptive Filtereinrichtung nach Anspruch 4, bei der die erste Abtastdaten-Filtereinrichtung (Z) und die zweiten Abtastdaten-Filter Digitalfilter sind.

6. Adaptive Filtereinrichtung nach Anspruch 5, bei der das Eingangssignal (u) von einem einzigen Analog-/Digital-Wandler erhalten wird.

7. Filtereinrichtung nach Anspruch 6, bei der der einzige Analog-/Digital-Wandler ein Ein-Bit(Sigma-Delta)-Wandler ist.

8. Filtereinrichtung nach Anspruch 5, bei der die ersten und zweiten Ausgangssignale (xh, xs) Digitalsignale sind, die kombiniert und an einen einzigen Digital-/Analog-Wandler weitergeleitet werden.

9. Filtereinrichtung nach Anspruch 8, bei der der einzige Digital-/Analog-Wandler ein Ein-Bit(Sigma-Delta)-Wandler ist.

10. Adaptives Filter nach Anspruch 1, bei dem die zusätzliche Filtereinrichtung (K) ein Analogfilter oder ein Verstärker ist.

11. Adaptives Filter nach Anspruch 10, bei dem das Analogfilter bzw. der Verstärker digital gesteuert wird.

12. Adaptives Filter nach Anspruch 1, bei dem die Adaptionseinrichtung derart betrieben wird, daß der mittlere Quadratwert des Fehlersignals (e) minimiert wird.

13. Adaptives Filter nach Anspruch 1, bei dem die Eingabeeinrichtung, die Ausgabeeinrichtung, die zusätzliche Filtereinrichtung (K) und die Kombiniereinrichtung auf einem einzigen IC-Chip implementiert sind.

14. Adaptives Filter nach Anspruch 1, bei dem die erste Abtastdaten-Filtereinrichtung (Z) ein digitales Filter ist und die erste Abtastdaten-Filtereinrichtung (Z) und die Adaptionseinrichtung auf einem einzigen IC-Chip implementiert sind.

15. Adaptives Mehrkanalfilter, das eine Mehrzahl von Einkanalfiltern (F11, F21, F12, F22, F13, F23) umfaßt, wobei jeder Einkanalfilter einem der vorhergehenden Ansprüche entspricht.

16. Steuersystem zum Reduzieren oder Modifizieren einer ursprünglichen Störung, wobei das System folgendes umfaßt:

   einen Eingabesensor, der ein Eingangssignal (INPUT 1) liefert, das zumindest teilweise in Bezug zu einer ursprünglichen Störung steht;
   ein adaptives Filter nach einem der Ansprüche 1 bis 14 zum Filtern des Eingangssignals (INPUT 1), um ein Treibersignal (OUTPUT 1) zu erzeugen;
   einen Aktuator, der auf die Treibersignale anspricht, um eine Steuerstörung zu erzeugen; und
   einen Abweichungssensor, der auf die Kombination einer ursprünglichen Störung und der Steuerstörung anspricht und ein Abweichungssignal (INPUT 2) erzeugt, wobei
   das adaptive Filter in Abhängigkeit von dem Abweichungssignal (INPUT 2) adaptiert wird.

17. Steuersystem nach Anspruch 16 einschließlich einer zusätzlichen Filtereinrichtung (L, W), um jegliche Rückkopplungen zwischen dem Aktuator und dem Eingabesensor zu kompensieren.

18. Verfahren zum Konfigurieren eines Filters gemäß einem der Ansprüche 1 bis 14, wobei das Verfahren folgendes umfaßt:

   Bilden einer Matrix $U$ aus gefilterten Eingangssignalen,
   Berechnen eines Vektors $\underline{C}$ aus Filterkoeffizienten gemäß

$$\underline{C} = -<U^T U>^{-1} <U^T \underline{y}>$$

   wobei $\underline{y}$ ein Vektor erwünschter Signale ist und die spitzen Klammern einen erwarteten Wert bezeichnen, und Anwenden von $\underline{C}$ auf ein Filter gemäß einem der Ansprüche 1 bis 14.

19. Verfahren zum Konfigurieren eines Filters gemäß einem der Ansprüche 1 bis 14, wobei das Verfahren folgendes umfaßt:

   Bilden einer Matrix $U_s$ aus gefilterten Eingangssignalen,
   Berechnen eines Vektors $\underline{C}$ aus Filterkoeffizienten gemäß

$$\underline{C} = -<U_s^T U_s>^{-1} <U_s^T H\underline{y}>$$

   wobei $\underline{y}$ ein Vektor erwünschter Signale und $H$ eine Matrix ist, die der Antwort der Antialiasing- und Anti-Abbildungs-Filter entspricht und die spitzen Klammern einen erwarteten Wert bezeichnen, und Anwenden von $\underline{C}$ auf ein Filter gemäß einem der Ansprüche 1 bis 14.

**Revendications**

1. Filtre adaptatif à faible retard de débit comprenant :

   - un moyen d'entrée pour recevoir un signal d'entrée (u);
   - un moyen de sortie pour générer en sortie un signal filtré (x);
   - un premier circuit de filtre entre le moyen d'entrée et le moyen de sortie, le premier circuit de filtre comprenant un moyen d'échantillonnage pour fournir un premier signal avec un premier taux d'échantillonnage, un premier moyen de filtre de données échantillonnées (Z) pour filtrer ledit premier signal afin de produire un second signal, et un moyen de filtre anti-imageur (F2) pour filtrer le second signal afin de produire un premier signal de sortie (xs);
   - un second circuit de filtre entre le moyen d'entrée et le moyen de sortie, le second circuit de filtre comprenant un moyen de filtre additionnel (K) possédant un faible retard de débit par rapport au premier moyen de filtre de données échantillonnées afin de filtrer des signaux d'entrée (u) à partir du moyen d'entrée pour produire un second signal de sortie (xh); et
   - un moyen de combinaison pour combiner ledit premier signal de sortie (xs) et ledit second signal de sortie (xh) afin de produire un signal de sortie combiné (x);

     caractérisé par :

   - un moyen de filtre anti-alias (F1) sur le premier circuit de filtre entre le moyen d'entrée et le moyen d'échantillonnage; et
   - un moyen d'adaptation sensible à un signal d'erreur (e) échantillonné selon ledit premier taux d'échantillonnage et configuré pour régler les caractéristiques dudit premier moyen de filtre de données échantillonnées et dudit moyen de filtre additionnel, ledit signal d'erreur (e) étant représentatif de la différence entre la réponse globale du filtre et une réponse désirée du filtre (y).

2. Filtre adaptatif selon la revendication 1, dans lequel ledit moyen d'adaptation est également sensible audit premier signal.

3. Filtre adaptatif selon la revendication 1, dans lequel ledit signal d'erreur (e) est filtré à travers des modèles dudit moyen de filtre anti-alias (F1) et dudit moyen de filtre anti-imageur (F2) avant d'être utilisé pour régler les caractéristiques dudit moyen de filtre additionnel (K).

4. Filtre adaptatif selon la revendication 1, dans lequel le moyen de filtre additionnel (K) comprend un ou plusieurs seconds filtres de données échantillonnées avec un second taux d'échantillonnage et un ou plusieurs coefficients, ledit second taux d'échantillonnage étant plus grand que ledit premier taux d'échantillonnage et le nombre de coefficients dans ledit second filtre de données échantillonnées étant inférieur au nombre de coefficients dans ledit premier filtre de données échantillonnées.

5. Moyen de filtre adaptatif selon la revendication 4, dans lequel ledit premier moyen de filtre de données échantillonnées (Z) et lesdits seconds filtres de données échantillonnées sont des filtres numériques.

6. Moyen de filtre adaptatif selon la revendication 5, dans lequel ledit signal d'entrée (u) est obtenu à partir d'un seul convertisseur d'analogique en numérique.

7. Moyen de filtre selon la revendication 6, dans lequel ledit convertisseur d'analogique en numérique est un convertisseur sur un bit (en sigma/delta).

8. Moyen de filtre selon la revendication 5, dans lequel lesdits premier et second signaux de sortie (xh, xs) sont des signaux numériques qui sont combinés et passent dans un seul convertisseur de numérique en analogique.

9. Moyen de filtre selon la revendication 8, dans lequel le convertisseur de numérique en analogique unique est un convertisseur sur un bit (en sigma/delta).

10. Filtre adaptatif selon la revendication 1, dans lequel le moyen de filtre additionnel (K) est un filtre ou un gain analogique.

**11.** Filtre adaptatif selon la revendication 10, dans lequel le filtre ou gain analogique est commandé de façon numérique.

**12.** Filtre adaptatif selon la revendication 1, dans lequel ledit moyen d'adaptation sert à minimiser la valeur quadratique moyenne dudit signal d'erreur (e).

**13.** Filtre adaptatif selon la revendication 1, dans lequel ledit moyen d'entrée, ledit moyen de sortie, ledit moyen de filtre additionnel (K) et ledit moyen de combinaison sont mis en oeuvre sur une seule puce de circuit intégré.

**14.** Filtre adaptatif selon la revendication 1, dans lequel ledit premier moyen de filtre de données échantillonnées (Z) est un filtre numérique et ledit premier moyen de filtre de données échantillonnées (Z) et ledit moyen d'adaptation sont mis en oeuvre sur une seule puce de circuit intégré.

**15.** Filtre adaptatif sur plusieurs canaux comprenant une pluralité de filtres à canal unique (F11, F21, F12, F22, F13, F23), chaque filtre à canal unique étant sélectionné selon une revendication précédente.

**16.** Système de commande pour la réduction ou la modification d'une perturbation d'origine, le système comprenant :

- un capteur d'entrée fournissant un signal d'entrée (INPUT 1) représentant au moins en partie une perturbation d'origine;
- un filtre adaptatif selon l'une quelconque des revendications 1 à 14 pour filtrer ledit signal d'entrée (INPUT 1) afin de produire un signal d'attaque (OUTPUT 1);
- un actionneur sensible auxdits signaux d'attaque afin de produire une perturbation de commande; et
- un capteur résiduel sensible à la combinaison d'une perturbation d'origine et de ladite perturbation de commande et produisant un signal résiduel (INPUT 2);

   dans lequel le filtre adaptatif est adapté selon ledit signal résiduel (INPUT 2).

**17.** Système de commande selon la revendication 16, comprenant des moyens additionnels de filtre (L, W) pour compenser une quelconque rétroaction entre l'actionneur et le capteur d'entrée.

**18.** Procédé de configuration d'un filtre selon une quelconque des revendications 1 à 14, le procédé comprenant :

- la formation d'une matrice U de signaux filtrés d'entrée;
- le calcul d'un vecteur $\underline{C}$ de coefficients de filtre selon la formule suivante :

$$\underline{C} = -<U^{T}U>^{-1}<U^{T}\underline{y}>$$

   où $\underline{y}$ est un vecteur des signaux désirés et les crochets désignent une valeur attendue; et
- l'application de $\underline{C}$ à un filtre selon l'une quelconque des revendications 1 à 14.

**19.** Procédé de configuration d'un filtre selon une quelconque des revendications 1 à 14, le procédé comprenant :

- la formation d'une matrice $U_s$ de signaux filtrés d'entrée;
- le calcul d'un vecteur $\underline{C}$ de coefficients de filtre selon la formule suivante :

$$\underline{C} = -<U_s{}^{T}U_s>^{-1}<U_s{}^{T}H\underline{y}>$$

   où $-\underline{y}$ est un vecteur des signaux désirés et H est une matrice correspondant à la réponse desdits filtres anti-alias et desdits filtres anti-imageurs et les crochets désignent une valeur prévue; et
- l'application de $\underline{C}$ à un filtre selon l'une quelconque des revendications 1 à 14.

# FIG.1

## PRIOR ART

SUMMING CIRCUIT

D-A CONVERTER

DIGITAL FILTER

A-D CONVERTER

TO LOUDSPEAKERS

INTEGRATING CIRCUIT

# FIG.2

## PRIOR ART

A

$I_{(t)}$

DIGITAL FILTER

$P_{(t)}$

FIG.3

FIG.4

FIG.5

FIG.6

FIG.7

FIG.8

# FIG.9

FIG.10

FIG.11

EP 0 660 958 B1

FIG.12